# EUROPÄISCHE PATENTSCHRIFT

(11) **EP 0 927 454 B1**
(45) Veröffentlichungstag und Bekanntmachung des Hinweises auf die Patenterteilung: **01.08.2001**
(21) Anmeldenummer: 97943745.6
(22) Anmeldetag: 08.09.1997
(51) Int. Cl.: H03H 9/145, H03H 9/05

(54) **OBERFLÄCHENWELLEN-BAUELEMENT**
SURFACE WAVE COMPONENT
COMPOSANT A ONDE DE SURFACE

(30) Priorität: 19.09.1996 DE 19638452
(43) Veröffentlichungstag der Anmeldung: 07.07.1999
(73) Patentinhaber: EPCOS AG, 81541 München (DE)
(72) Erfinder: SCHROPP, Isidor, D-85119 Ernsgaden (DE); OSTNER, Helmut, D-81675 München (DE); MACHUI, Jürgen, D-80809 München (DE); BAIER, Thomas, D-81539 München (DE)
(74) Vertreter: Epping, Wilhelm, Dipl.-Ing.
(86) Internationale Anmeldenummer: DE9701994
(87) Internationale Veröffentlichungsnummer: WO9812803

(56) Entgegenhaltungen:
- PATENT ABSTRACTS OF JAPAN vol. 096, no. 009, 30.September 1996 & JP 08 139559 A (KYOCERA CORP), 31.Mai 1996,
- PATENT ABSTRACTS OF JAPAN vol. 014, no. 229 (E-0928), 15.Mai 1990 & JP 02 058915 A (MURATA MFG CO LTD), 28.Februar 1990,
- PATENT ABSTRACTS OF JAPAN vol. 009, no. 270 (E-353), 26.Oktober 1985 & JP 60 114010 A (TOSHIBA KK), 20.Juni 1985,
- PATENT ABSTRACTS OF JAPAN vol. 095, no. 011, 26.Dezember 1995 & JP 07 231242 A (HITACHI LTD), 29.August 1995,

## Beschreibung

Die vorliegende Erfindung betrifft ein OberflächenwellenBauelement nach dem Oberbegriff des Patentanspruches 1.

Ein solches Oberflächenwellenbauelement, welches zwei getrennte akustische Spuren aufweist, die über Koppelwandler miteinander verbunden sind, und welches zur Anpassung an eine äußere Schaltungsumgebung eine auf dem OFW-Bauelement integrierte Spule aufweist, ist beispielsweise aus JP-A-8-139559 bekannt.

Oberflächenwellen-Bauelemente, die mit akustischen Oberflächenwellen arbeiten, beispielsweise mit akustischen Oberflächenwellen arbeitende Filter - OFW-Filter -, benötigen für die Anpassung an externe Impedanzen elekronische Netzwerke, die typischerweise aus Induktivitäten und/oder Kapazitäten bestehen.

Ein Oberflächenwellenbauelement, bei dem ein auf der Oberfläche des Bauelements angeordneter Reflektor gleichzeitig als Induktivität dient, ist beispielsweise aus der JP-A-02-058915 bekannt.

Zusätzlich können zur Verbesserung der Übertragungseigenschaften, z.B. Veränderung der Bandbreite, Verbesserung der Einfügedämpfung, Erhöhung der Filterselektion, Verbesserung der Anpaßbarkeit von Filtern, externe Bauteile an das OFW-Filter angeschaltet werden. Dabei handelt es sich um den Einsatz als Koppelelement.

Derartige elektronische Netzwerke bzw. Bauteile können entweder als externe diskrete Elemente oder als im Gehäuse von OFW-Filtern untergebrachte diskrete Elemente eingefügt werden.

Ein Oberflächenwellenbauelement mit einer auf dem Bauelementsubstrat integrierten Induktivität zur Verbesserung der Bauelementeigenschaften ist beispielsweise aus der JP-A-60114010 bekannt. Dabei handelt es sich um einen in einer akustischen Spur angeordneten Oberflächenwellenresonator.

Der vorliegenden Erfindung liegt die Aufgabe zugrunde, eine möglichst platzsparende Einfügungsmöglichkeit von Induktivitäten der elektronischen Netzwerke bzw. Bauteile in OFW-Bauelemente anzugeben.

Diese Aufgabe wird bei einem OFW-Bauelement der eingangs genannten Art erfindungsgemäß durch die Maßnahme des Patentanspruchs 1 gelöst.

Die Bauform der Induktivität kann im Rahmen der verfügbaren Technologie, des Substrats und des benötigten Wertes frei gewählt werden. Bei Annahme einer mäanderförmigen bzw. spiralförmigen Struktur der Induktivität lassen sich auf relativ kleiner Fläche große Induktivitätswerte erzielen.

Weiterbildungen der Erfindung sind Gegenstand von Unteransprüchen.

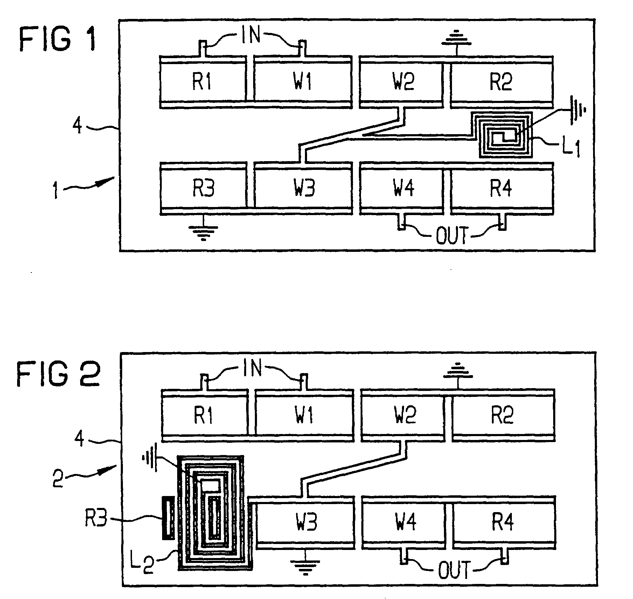

Die Erfindung wird nachfolgend anhand von Ausführungsbeispielen gemäß den Figuren der Zeichnung näher erläutert. Es zeigen dabei die Figuren 1 und 2 jeweils eine Ausführungsform eines erfindungsgemäßen OFW-Bauelements in schematischer Aufsicht.

In den Figuren sind gleiche Elemente jeweils mit gleichen Bezugszeichen bezeichnet.

Gemäß Fig. 1 umfaßt ein OFW-Bauelement gemäß der Erfindung, nämlich ein OFW-Filter 1, ein piezoelektrisches Substrat 4, auf dem in getrennten akustischen Spuren Reflektoren R1 bis R4, über Koppelwandler W2, W3 miteinander gekoppelte Ein- und Ausgangswandler W1 bzw. W4 und eine in das OFW-Filter integrierte Koppelspule L₁ angeordnet sind. Derartige Systeme sind an sich bekannt, weshalb es sich erübrigt, sie näher zu erläutern.

In der gezeigten Ausführungsform nach Fig. 1 ist die Koppelspule L₁ zu den Koppelwandlern W2, W3 parallel geschaltet. Je nach Bedarf kann diese Parallelschaltung durch eine Serienschaltung der Koppelspule zu den Koppelwandlern W2, W3 ersetzt sein. Je nach OFW-Filter können an die Stelle der zwei akustischen Spuren und der einen Koppelspule L₁ gemäß Fig. 1 mehrere akustische Spuren und dementsprechend mehrere wahlweise parallel oder in Serien geschaltete Koppelspulen treten.

Das OFW-Filter 2 nach Fig. 2 umfaßt vier in den akustischen Spuren angeordnete Reflektoren R1 bis R4 und eine in den Reflektor R3 integrierte Koppelspule L₂, die spiralförmige Struktur besitzt und zu den Koppelwandlern W2, W3 parallel geschaltet ist.

Auch hier kann die Parallelschaltung bei Bedarf durch eine Serienschaltung mit mindestens einem Wandler ersetzt sein.

Vorstehend aufgezeigte Integrationsmöglichkeiten für die Induktivität sind nur beispielhaft. Denkbar ist letztlich jede beliebige, durch die gewünschte Anpassung bestimmte Anordnung der Induktivitäten in Parallel- oder Serienschaltung zu einem oder mehreren der Koppel-Wandler.

## Patentansprüche

1. Oberflächenwellen-Bauelement, das mit akustischen Oberflächenwellen arbeitet,
mit in getrennten akustischen Spuren angeordneten, über Koppelwandler (W2, W3) miteinander gekoppelten Ein- und Ausgangswandlern (W1, W4) und mindestens einer auf dem Substrat (4) in das OFW-Bauelement (1) integrierten Spule,
**dadurch gekennzeichnet,** daß
die Spule eine mit den Koppelwandlern verschaltete Koppelspule (L₁, L₂) ist.

2. OFW-Bauelement nach Anspruch 1,
mit mehreren akustischen Spuren, mit in jeweils einer der Spuren angeordneten interdigitalen Ein- bzw. Ausgangswandler (W1) bzw. (W4) und mit integrierten Koppelspulen (L₁), die zu den Koppelwandlern (W2, W3) parallel geschaltet sind.

3. OFW-Bauelement nach Anspruch 1,
mit mehreren akustischen Spuren mit in jeweils einer der Spuren angeordnetem interdigitalen Ein- bzw. Ausgangswandler und integrierten Koppelspulen, die zu den Koppelwandlern in Serie geschaltet sind.

4. OFW-Bauelement nach Anspruch 1 oder 2,
mit mindestens einem, in den akustischen Spuren angeordneten Reflektor (R1) bis (R4) und mit einer mindestens in einen Reflektor (R3) integrierten Induktivität (L₂), die zu den Koppelwandlern (W2, W3) parallel geschaltet ist.

5. OFW-Bauelement nach einem der Ansprüche 1 bis 4,
bei dem die Induktivität (L₁; L₂; L₃; L₄) mäander- oder spiralförmige Struktur aufweist.

## Claims

1. Surface acoustic wave component operating with surface acoustic waves,
having input and output converters (W1, W4), which are arranged in separate acoustic tracks and are coupled to one another via coupling converters (W2, W3), and at least one coil integrated into the SAW component (1) on the substrate (4),
characterized in that
the coil is a coupling coil (L₁, L₂) connected up to the coupling converters.

2. SAW component according to Claim 1,
having a plurality of acoustic tracks, having interdigital input and output converters (W1) and (W4), respectively, arranged in a respective one of the tracks, and having integrated coupling coils (L₁), which are connected in parallel with the coupling converters (W2, W3).

3. SAW component according to Claim 1,
having a plurality of acoustic tracks having interdigital input and output converters arranged in a respective one of the tracks, and integrated coupling coils, which are connected in series with the coupling converters.

4. SAW component according to Claim 1 or 2,
having at least one reflector (R1) to (R4), arranged in the acoustic tracks, and having an inductor (L₂), which is integrated at least into a reflector (R3) and is connected in parallel with the coupling converters (W2, W3).

5. SAW component according to one of Claims 1 to 4,
in which the inductor (L₁; L₂; L₃; L₄) has a meander-shaped or spiral structure.

## Revendications

1. Composant à onde de surface qui fonctionne par des ondes de surface acoustiques,
comportant des transducteurs (W1, W4) d'entrée et de sortie montés dans des traces acoustiques distinctes et couplés l'un à l'autre par l'intermédiaire de transducteurs de couplage, et au moins une bobine intégrée au composant (1) à onde de surface sur le substrat (4),
caractérisé en ce que la bobine est une bobine (L₁, L₂) de couplage connectée aux transducteurs de couplage.

2. Composant à onde de surface suivant la revendication 1,
comportant plusieurs traces acoustiques, comportant des transducteurs (W1 et W4) d'entrée et de sortie interdigités, montés chaque fois dans l'une des traces, et comportant des bobines (L₁) de couplage intégrées qui sont branchées en parallèle avec les transducteurs (W2, W3) de couplage.

3. Composant à onde de surface suivant la revendication 1,
comportant plusieurs traces acoustiques, comportant des transducteurs d'entrée et de sortie montés chaque fois dans l'une des traces, et des bobines de couplage intégrées qui sont branchées en série avec les transducteurs de couplage.

4. Composant à onde de surface suivant la revendication 1 ou 2,
comportant au moins un réflecteur (R1 à R4) monté dans les traces acoustiques et comportant une inductance (L₂) qui est intégrée au moins à un réflecteur (R3) et qui est branchée en parallèle avec les transducteurs (W2, W3) de couplage.

5. Composant à onde de surface suivant l'une des revendications 1 à 4,
dans lequel l'inductance (L₁ ; L₂ ; L₃ ; L₄) a une structure sinueuse ou spiralée.
